# FASCICULE DE BREVET EUROPEEN

(11) **EP 2 896 067 B1**
(45) Date de publication et mention de la délivrance du brevet: **01.02.2017**
(21) Numéro de dépôt: 13762813.7
(22) Date de dépôt: 13.09.2013
(51) Int. Cl.: H01L 23/10, H01L 23/12, H01L 23/13, H01L 23/14, H01L 23/31, H01L 23/00, H05K 1/11, H05K 1/18, H05K 3/46, H05K 3/00

(54) **CAPOT POUR DISPOSITIF À RAINURE ET À PUCE, DISPOSITIF EQUIPE DU CAPOT, ASSEMBLAGE DU DISPOSITIF AVEC UN ÉLÉMENT FILAIRE ET PROCÉDÉ DE FABRICATION**
KAPPE FÜR EINE CHIPVORRICHTUNG MIT EINER NUT, VORRICHTUNG MIT BESAGTER KAPPE, BAUGRUPPE AUS DIESER KAPPE UND EINEM DRAHTELEMENT SOWIE HERSTELLUNGSVERFAHREN DAFÜR
CAP FOR A CHIP DEVICE HAVING A GROOVE, DEVICE PROVIDED WITH SAID CAP, ASSEMBLY CONSISTING OF THE DEVICE AND A WIRE ELEMENT, AND MANUFACTURING METHOD THEREOF

(30) Priorité: 17.09.2012 FR 1258687
(43) Date de publication de la demande: 22.07.2015
(73) Titulaire: Commissariat à l'Énergie Atomique et aux Énergies Alternatives, 75015 Paris (FR)
(72) Inventeur: VICARD, Dominique, F-38190 Bernin (FR); BRUN, Jean, F-38800 Champagnier (FR)
(74) Mandataire: Novaimo
(86) Numéro de dépôt international: PCT/EP2013/068972
(87) Numéro de publication internationale: WO 2014/041107

(56) Documents cités:
- EP-A1- 2 099 060
- FR-A1- 2 937 464
- FR-A1- 2 960 339
- FR-A1- 2 964 786
- US-A1- 2011 127 655
- US-B1- 6 351 028

## Description

### Domaine technique de l'invention

L'invention concerne le domaine de la microélectronique.

L'invention a pour objet plus particulièrement un capot destiné à être assemblé avec au moins un élément à puce.

### État de la technique

Dans le domaine des puces électroniques, notamment à intégrer avec un élément filaire, il existe des dispositifs équipés d'un élément à puce sur lequel est monté un capot de sorte à délimiter une rainure d'encastrement de l'élément filaire. L'élément à puce comporte une borne de connexion agencée sur une partie de l'élément à puce qui délimite aussi une partie de la rainure. Cette borne permet de connecter électriquement l'élément filaire encastré dans la rainure à la puce de l'élément à puce.

Afin de réaliser un encastrement correct de l'élément filaire et d'assurer un bon contact électrique entre l'élément filaire et la borne de connexion, il est préférable que les dimensions de la rainure soient précises et facilement reproductibles d'un dispositif à l'autre.

Un tel capot peut être réalisé comme décrit dans le document FR2960339 de la demanderesse, en mettant en oeuvre une étape d'injection permettant de mouler un capot. Ceci nécessite de fabriquer les capots directement sur les éléments à puce par durcissement d'une matière.

Les documents FR 2 937 464 A1, FR 2 960 339 A1, FR 2 964 786 A1, EP 2 099 060 A1, US 6 351 028 B1 et US 2011/127655 divulguent des capots semblables.

### Objet de l'invention

Le but de la présente invention est de proposer une solution alternative à celle de l'art antérieur, proposant notamment une fabrication indépendante des capots.

On tend vers ce but en ce que le capot est destiné à être assemblé avec au moins un élément à puce, et en ce que ledit capot comporte un empilement d'une pluralité de couches électriquement isolantes délimitant au moins un épaulement formant une partie d'une première rainure de logement d'un élément filaire. En outre, le capot comporte : au moins un plot de contact électrique agencé au niveau d'une surface d'assemblage de l'empilement destinée à être montée sur une face de l'élément à puce ; au moins une borne de connexion électrique agencée au niveau d'une paroi de l'épaulement ; un élément de liaison électrique reliant électriquement ladite borne de connexion électrique au plot de contact électrique.

La paroi de l'épaulement associée à la borne de connexion électrique peut être inclue dans un plan décalé par rapport au plan incluant la surface d'assemblage.

Selon une mise en oeuvre de l'élément de liaison électrique, ce dernier peut comporter au moins un premier élément électriquement conducteur intercalé entre deux couches électriquement isolantes de l'empilement. En outre, l'élément de liaison électrique peut comporter au moins un deuxième élément électriquement conducteur séparé du premier élément électriquement conducteur par au moins une des couches électriquement isolantes de l'empilement. Par ailleurs, ladite au moins une couche électriquement isolante séparant les premier et deuxième éléments électriquement conducteurs peut comporter un trou traversé par un troisième élément électriquement conducteur de l'élément de liaison électrique, ledit troisième élément électriquement conducteur reliant électriquement le premier élément électriquement conducteur au deuxième élément électriquement conducteur.

Selon une réalisation, l'empilement comporte un circuit imprimé dont au moins une piste imprimée, notamment entre deux couches électriquement isolantes superposées, forme au moins une partie de l'élément de liaison électrique.

Selon un exemple particulier, l'épaulement coopère avec un autre épaulement dudit capot de sorte à délimiter la première rainure.

Le capot peut comporter au moins une deuxième rainure, dissociée de l'épaulement de la première rainure, dont les parois sont formées toutes ou en partie par des faces du capot.

Selon une réalisation, le capot comprend au moins une borne de connexion électrique additionnelle formée au niveau d'une des parois de la deuxième rainure. Par ailleurs, l'élément de liaison électrique peut relier électriquement la borne de connexion électrique additionnelle audit plot de contact électrique, et/ou la borne de connexion électrique additionnelle peut être reliée électriquement à un plot de contact électrique additionnel, disposé au niveau de la surface destinée à être montée sur la face de l'élément à puce, par un élément de liaison électrique additionnel.

L'invention est aussi relative à un dispositif comportant un élément à puce muni d'au moins une puce électronique, un capot tel que décrit assemblé à l'élément à puce, au moins une rainure destinée à recevoir un élément filaire et délimitée au moins en partie par l'épaulement du capot, et au moins une borne de connexion électrique disposée dans la rainure et reliée électriquement à ladite puce de l'élément à puce.

Avantageusement, l'élément à puce comprend au moins un organe de connexion électrique de la puce relié électriquement à un plot de contact électrique associé du capot de sorte à relier électriquement la puce à la borne de connexion électrique disposée au niveau de l'épaulement du capot.

Selon une mise en oeuvre, la rainure comporte deux parois latérales opposées se faisant face, l'une des parois latérales étant formée par une partie de l'élément à puce et l'autre paroi latérale par une partie de l'épaulement du capot, la borne de connexion électrique étant disposée au niveau de la paroi latérale associée au capot.

L'invention est aussi relative à un assemblage comprenant un dispositif tel que décrit et un élément filaire au moins partiellement électriquement conducteur monté dans la rainure, ledit élément filaire étant en contact électrique avec la borne de connexion électrique.

L'invention est aussi relative à un procédé de fabrication comportant une étape de réalisation d'au moins un capot tel que décrit.

Selon une mise en oeuvre du procédé, l'étape de réalisation du capot comprend :
- Une étape de formation d'une première partie d'un empilement de couches électriquement isolantes,
- une étape de formation d'une deuxième partie de l'empilement de couches électriquement isolantes configurée de sorte à délimiter, avec la première partie de l'empilement de couches, l'épaulement destiné à délimiter au moins en partie la première rainure.

Par ailleurs, l'étape de réalisation du capot comprend une étape de réalisation d'une borne de connexion électrique au niveau de l'épaulement, d'un plot de contact électrique au niveau de la deuxième partie de empilement de couches, et d'un élément de liaison électrique cheminant dans la deuxième partie de empilement de couches, ou dans la première partie et la deuxième partie de l'empilement de couches électriquement isolantes.

Selon une autre mise en oeuvre du procédé, l'étape de réalisation permettant de réaliser une pluralité de capots, elle comporte :
- Une étape de formation d'un premier ensemble de couches superposées électriquement isolantes,
- Une étape de formation d'une pluralité de deuxièmes ensembles de couches électriquement isolantes superposées sensiblement parallèles les uns aux autres et s'étendant chacun à partir d'une même face du premier ensemble de couches, les deuxièmes ensembles de couches adjacents étant séparés par une portion de séparation de la face du premier ensemble de couches les portant.

Le procédé peut comporter une étape d'individualisation des capots. Cette étape d'individualisation des capots peut comporter :
- Une première étape de découpe du premier ensemble de couches au niveau de chaque portion de séparation selon une première ligne de découpe correspondante,
- Une deuxième étape de découpe du premier ensemble de couches et du deuxième ensemble de couches selon au moins une deuxième ligne de découpe sécante à la première ligne de découpe.

De préférence, avant l'étape d'individualisation des capots, le procédé comporte une étape de report d'un substrat comprenant une pluralité d'éléments à puce de sorte à associer aux futurs capots les éléments à puce.

Les première et deuxième étapes de découpe peuvent être configurées de sorte à séparer aussi les différents éléments à puce les uns des autres après l'étape de report du substrat.

Avantageusement, l'étape de formation de la pluralité de capots comporte pour chaque futur capot les étapes suivantes :
- réaliser au moins une borne de connexion électrique au niveau du premier ensemble de couches ou au niveau du deuxième ensemble de couches correspondant,
- réaliser au moins un plot de contact électrique au niveau du premier ensemble ou du deuxième ensemble de couches correspondant,
réaliser au moins un élément de liaison électrique cheminant dans le premier ensemble de couches et/ou dans le deuxième ensemble de couches correspondant, et reliant électriquement ladite borne de connexion électrique et ledit plot de contact électrique.

### Description sommaire des dessins

D'autres avantages et caractéristiques ressortiront plus clairement de la description qui va suivre de modes particuliers de réalisation de l'invention donnés à titre d'exemples non limitatifs et représentés sur les dessins annexés, dans lesquels :
- la figure 1 est une vue de côté d'un capot, selon un mode de réalisation, assemblé à un élément à puce,
- la figure 2 est une vue représentant une variante de réalisation du capot assemblé à un élément à puce de la figure 1,
- la figure 3 est une vue représentant une autre variante de réalisation du capot assemblé à un élément à puce,
- la figure 4 illustre plus en détail une réalisation particulière d'un capot,
- les figures 5, 6 et 7 illustre différentes coupes de la figure 4,
- la figure 8 illustre plus en détail une autre réalisation particulière d'un capot pouvant être associée à la figure 3,
- la figure 9 illustre un dispositif muni d'un capot et d'un élément à puce, ledit dispositif étant assemblé à un élément filaire,
- la figure 10 permet d'illustrer un procédé de fabrication d'un capot,
- la figure 11 illustre une étape de fabrication d'une pluralité de capots,
- la figure 12 illustre une autre étape de fabrication d'une pluralité de capots,
- la figure 13 illustre la figure 12 vue sous un autre angle,
- la figure 14 illustre une autre étape de fabrication dans laquelle la pluralité de capots est associée à des éléments à puce,
- la figure 15 illustre en perspective un dispositif à plusieurs étages permettant de connecter plusieurs éléments filaires dans des rainures différentes,
- la figure 16 illustre une vue éclatée d'un dispositif muni d'un capot permettant d'exemplifier les dimensions d'un tel dispositif,
- la figure 17 est une vue représentant une variante de réalisation d'un capot assemblé à deux éléments à puce.

### Description de modes préférentiels de l'invention

Le capot décrit ci-après diffère de l'art antérieur notamment en ce qu'il est fabriqué à base d'un empilement de couches électriquement isolantes. Les empilements de couches sont des technologies maitrisées qui permettent entre autre d'assurer une fabrication reproductible et donc un écart reproductible et précis entre des parois d'une rainure.

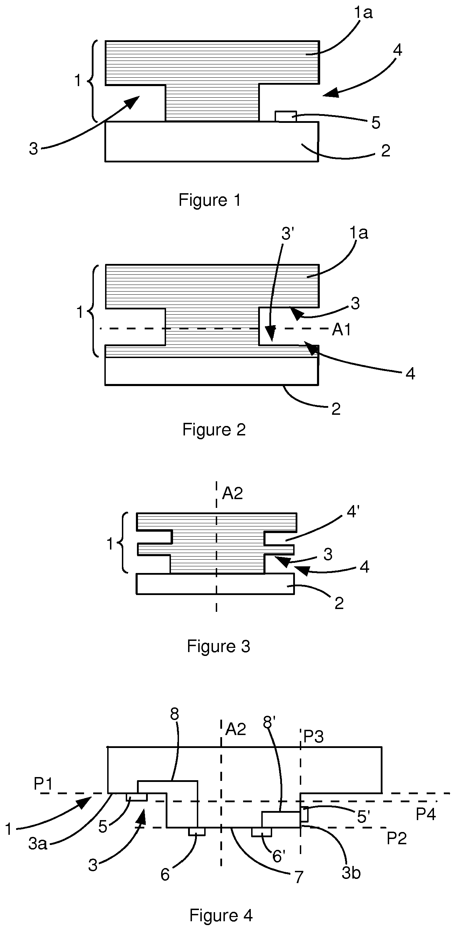

Comme illustré aux figures 1 et 2, le capot 1, destiné à être assemblé avec au moins un élément à puce 2 (sur les figures 1 et 2, le capot 1 est montré assemblé à un élément à puce 2 correspondant), comporte un empilement d'une pluralité de couches électriquement isolantes 1a (de préférence au moins trois couches électriquement isolantes) délimitant au moins un épaulement 3 formant une partie d'une première rainure 4 de logement d'un élément filaire (non représenté).

De préférence, le capot peut former une protection au moins partielle d'un élément à puce. En outre, de préférence, le capot ne comporte pas de fonctions électroniques hormis le cas échéant un simple routage électrique.

Les couches électriquement isolantes de l'empilement peuvent être réalisées dans un même matériau et avoir avantageusement la même épaisseur.

L'empilement est, de préférence, réalisé de sorte qu'une fois assemblé avec un élément à puce, les couches empilées s'élèvent de l'élément à puce en s'éloignant petit à petit de l'élément à puce.

Sur la figure 1, l'épaulement 3 coopère avec l'élément à puce 2 pour délimiter une rainure 4. Avantageusement, le capot 1 présente une section en « T » délimitant deux épaulements opposés destinés à former, lorsque le capot 1 associé est assemblé à un élément à puce 2 correspondant, deux rainures opposées.

Sur la figure 2, l'épaulement 3 coopère avec un autre épaulement 3' dudit capot 1 de sorte à délimiter la première rainure 4. Ces deux épaulements 3, 3' sont disposés de manière opposée par rapport à un axe A1, parallèle à la surface de contact ou d'assemblage de l'empilement et de l'élément à puce 2, et se font face. Avantageusement, le capot 1 illustré présente une section en « H » délimitant deux rainures opposées.

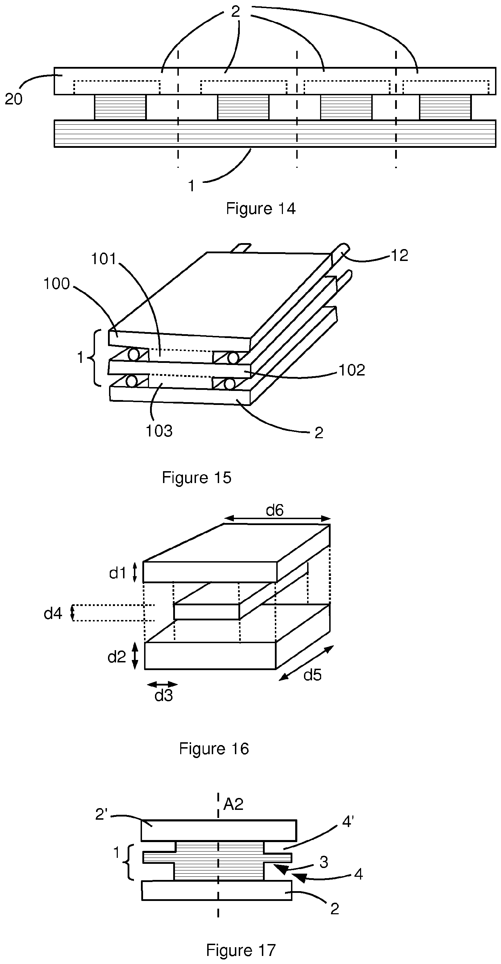

Selon une variante illustrée à la figure 3, notamment applicable aux deux réalisations des figures 1 et 2, le capot 1 comporte au moins une deuxième rainure 4', dissociée de l'épaulement 3 de la première rainure 4, dont les parois sont formées toutes ou en partie par des faces dudit capot 1. De préférence, les parois de la deuxième rainure 4' sont formées uniquement par le capot 1 (figure 3) ou bien en partie par le capot 1 et par une surface d'un autre élément à puce 2' tel qu'illustré à la figure 17 qui reprend toutes les références communes avec la figure 3. Sur la figure 17, le capot est pris en sandwich entre deux éléments à puce. Autrement dit, selon un axe A2, dans l'exemple représenté perpendiculaire à la surface de contact ou d'assemblage de l'empilement et de l'élément à puce 2, il est possible d'échelonner selon des intervalles idoines plusieurs rainures de logement d'un élément filaire. Cet axe A2 est sensiblement perpendiculaire au plan incluant l'élément à puce 2. Avantageusement, le capot peut comporter plusieurs plans chacun associé à deux rainures et décalés les uns des autres le long de l'axe A2, lesdits plans étant sensiblement perpendiculaires à cet axe A2 de sorte à s'éloigner un à un de l'élément à puce 2.

L'empilement de couches électriquement isolantes peut être réalisé en utilisant les techniques issues de la technologie PCB (pour « Printed Circuit Board » ou circuit imprimé en français).

Sur la figure 1, l'élément à puce comporte dans la rainure 4 une borne de connexion 5 destinée à connecter un élément filaire à une puce de l'élément à puce 2.

Outre l'avantage particulier de réalisation de tels capots de manière reproductible, l'utilisation de couches électriquement isolantes permet avantageusement de déporter au niveau du capot 1 la borne de connexion électrique 5 de l'élément filaire montée dans la rainure usuellement au niveau de l'élément à puce 2.

Autrement dit, comme illustré à la figure 4, le capot 1 peut comporter au moins un plot de contact électrique 6, 6' agencé au niveau d'une surface d'assemblage 7 de l'empilement destinée à être montée sur une face de l'élément à puce 2, et au moins une borne de connexion électrique 5, 5' agencée au niveau d'une paroi 3a, 3b de l'épaulement 3 du capot 1. Bien entendu, le capot 1 comporte aussi un élément de liaison électrique 8, 8' reliant ladite borne de connexion électrique 5, 5' au plot de contact électrique 6, 6'. Avantageusement, la réalisation des liaisons électriques dans le capot permet notamment une meilleure protection de ces dernières.

De manière générale, un épaulement tel que décrit dans la présente description peut comporter comme l'illustre la figure 4 deux parois 3a, 3b agencées de manière idoine avec le reste du capot pour permettre d'aménager un logement de réception, de préférence allongé, d'un élément filaire. Ce logement est complété par le montage de l'élément à puce 2 avec le capot 1 de sorte à délimiter une rainure dont un fond et une paroi latérale, s'étendant du fond, sont formés par ledit épaulement, l'autre paroi latérale de la rainure étant alors formée par une partie dudit élément à puce 2. Autrement dit, les deux parois 3a, 3b sont sécantes et présentent une interface de liaison l'une avec l'autre à partir de laquelle lesdites parois 3a, 3b s'étendent en formant un évasement.

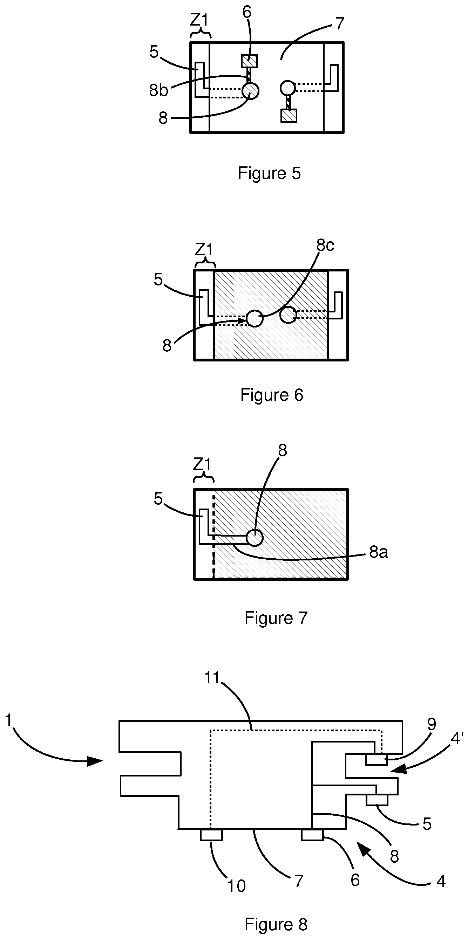

Il est à noter que la figure 4, ainsi que la figure 8 décrite ci-après montrent un élément de liaison 8 représenté selon un simple trait. Pour des besoins de clarté, les couches de l'empilement n'ont pas été représentées. Ainsi, il faut comprendre que l'élément de liaison 8 n'est pas enterré mais est un élément métallique pouvant comprendre une partie traversant de part en part au moins une couche de l'empilement et/ou une partie prise en sandwich entre deux couches de l'empilement.

Par « surface d'assemblage », on entend la surface 7 du capot 1 destinée à être monté sur un élément à puce 2, par exemple par collage ou tout autre moyen idoine permettant d'assembler ces deux éléments (capot/élément à puce) entre eux.

Selon une mise en oeuvre particulière, la paroi 3a de l'épaulement 3 associée à la borne de connexion électrique 5 est inclue dans un plan P1 décalé par rapport à un plan P2 incluant la surface d'assemblage 7. Sur la figure 4, P1 et P2 sont des plans sensiblement parallèles, perpendiculaires au plan de la figure 4, et décalés le long de l'axe A2.

Selon une autre mise en oeuvre particulière, la paroi 3b de l'épaulement associée à la borne de connexion électrique 5' est inclue dans un plan P3 sensiblement perpendiculaire au plan P2 incluant la surface d'assemblage 7.

Les deux mises en oeuvre décrites ci-dessus peuvent être combinées l'une avec l'autre au niveau d'un même capot, par exemple au niveau de rainures différentes, ou encore d'une même rainure.

Le déport de telles connexions dans un capot peut être mis en oeuvre grâce à des métallisations réalisées entre les couches électriquement isolantes afin d'assurer un routage idoine entre la borne de connexion électrique 5 et le plot de contact électrique 6 destiné à être connecté avec un organe de connexion de l'élément à puce associé à la puce de l'élément à puce. Autrement dit, l'empilement peut comporter un circuit imprimé dont au moins une piste imprimée, notamment entre deux couches électriquement isolantes superposées, forme au moins une partie de l'élément de liaison électrique.

Les figures 5, 6 et 7 illustrent respectivement des coupes réalisées au niveau des plans P2, P4 et P1 de la figure 4. A la figure 5, on voit la surface d'assemblage 7 au niveau de laquelle est formé le plot de contact électrique 6. A la figure 6, on voit l'élément de liaison 8 qui chemine dans l'empilement de sorte à déporter la borne de connexion électrique 5 de la (figure 7) au niveau d'une zone Z1 correspondant à une paroi de rainure.

Selon une réalisation particulière, l'élément de liaison électrique 8 peut comporter au moins un premier élément électriquement 8a conducteur intercalé entre deux couches électriquement isolantes de l'empilement du capot. En outre, l'élément de liaison électrique 8 peut comporter au moins un deuxième élément électriquement conducteur 8b séparé du premier élément électriquement conducteur 8a par au moins une des couches électriquement isolantes de l'empilement. Enfin, ladite au moins une couche électriquement isolante séparant les premier et deuxième éléments électriquement conducteurs 8a, 8b peut comporter un trou traversé par un troisième élément électriquement 8c conducteur de l'élément de liaison électrique 8, ledit troisième élément électriquement conducteur 8c reliant électriquement le premier élément électriquement conducteur 8a au deuxième élément électriquement conducteur 8b. Ce trou peut être un via métallisé tels qu'ils sont communément utilisés dans la technologie PCB.

Il a été précisé ci-avant que le capot 1 pouvait comprendre une deuxième rainure 4', notamment dissociée de l'épaulement 3 de la première rainure 4 et dont les parois sont formées en toute ou partie par des faces du capot. Dès lors, comme illustré à la figure 8, le capot 1 peut comprendre une borne de connexion électrique additionnelle 9 formée au niveau d'une des parois de la deuxième rainure 4'. Avantageusement, l'élément de liaison électrique 8 relie électriquement la borne de connexion électrique additionnelle 9 audit plot de contact électrique 6, et/ou la borne de connexion électrique additionnelle 9 est reliée électriquement à un plot de contact électrique additionnel 10, disposé au niveau de la surface 7 destinée à être montée sur la face de l'élément à puce, par un élément de liaison électrique additionnel 11. Ainsi, les bornes de connexion 5, 9 des rainures 4 et 4' peuvent être reliées électriquement entre elles par un même élément de liaison 8 à un même organe de connexion de l'élément à puce, ou être totalement dissociées.

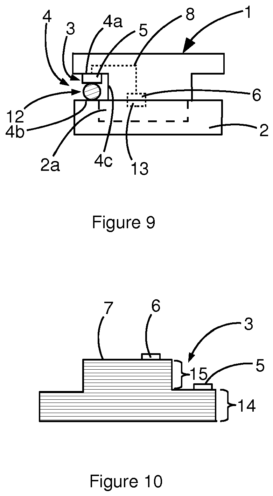

On comprend de ce qui a été dit ci-dessus que le capot 1 est destiné à être assemblé à un élément à puce 2 pour former un dispositif. Comme illustré à la figure 9, un tel dispositif comporte un élément à puce 2 muni d'au moins une puce électronique 2a, un capot 1 tel que défini précédemment et assemblé à l'élément à puce 2, au moins une rainure 4 destinée à recevoir un élément filaire 12 et délimitée au moins en partie par l'épaulement 3 du capot 1, et au moins une borne de connexion 5 électrique disposée dans la rainure 4 et reliée électriquement à ladite puce 2a de l'élément à puce 2.

La borne de connexion 5 peut être disposée au niveau de l'élément à puce 2, ou comme sur la figure 9 au niveau de l'épaulement 3. Par au niveau de l'élément à puce 2, on entend ici que la borne de connexion 5 s'étend à partir de l'élément à puce, et par au niveau de de l'épaulement on entend ici que la borne de connexion 5 s'étend à partir d'une paroi délimitant ledit épaulement 3.

Toutes les variantes du capot telles que décrites ci-avant peuvent s'appliquer au dispositif.

Ainsi, par exemple comme illustré à la figure 9, l'élément à puce 2 comprend au moins un organe de connexion électrique 13 de la puce 2a relié électriquement à un plot de contact électrique 6 associé du capot 1 de sorte à relier électriquement la puce 2a à la borne de connexion électrique 5 disposée au niveau de l'épaulement 3 du capot 1. Ce lien électrique entre la borne de connexion électrique 5 et le plot de contact électrique 6 peut notamment être mis en oeuvre par l'élément de liaison 8.

Selon une mise en oeuvre illustrée à la figure 9, la rainure 4 comporte deux parois latérales opposées 4a, 4b se faisant face, l'une des parois latérales 4b étant formée par une partie de l'élément à puce 2 et l'autre paroi latérale 4a par une partie de l'épaulement 3 du capot 1, la borne de connexion électrique 5 étant disposée au niveau de la paroi latérale 4a associée au capot 1. Par exemple, la borne de connexion électrique 5 peut s'étendre à partir de la paroi 4a associée au capot 1 en direction de la paroi 4b associée à l'élément à puce 2. Sur l'exemple, les parois latérales 4a et 4b sont reliées entre elles par une paroi 4c délimitant un fond de rainure 4. Cette paroi 4c pourrait aussi supporter la borne de connexion à la place de la paroi 4a.

Un assemblage peut comprendre un dispositif tel que décrit et un élément filaire 12 au moins partiellement électriquement conducteur monté dans la rainure 4. L'élément filaire 12 est en contact électrique avec la borne de connexion électrique 5. Ainsi, l'élément filaire électriquement conducteur peut être relié électriquement à la puce 2a de l'élément à puce 2.

De manière générale, la rainure du dispositif comporte deux parois latérales se faisant face, et par exemple reliées par un fond de la rainure. Une rainure est avantageusement ouverte à ses deux extrémités opposées de sorte à permettre un encastrement longitudinal d'un élément filaire associé. L'élément filaire 12 peut être maintenu préférentiellement par pincement entre la borne de connexion électrique 5 portée par l'une des parois latérales de la rainure 4 et l'autre paroi latérale de la rainure 4. Ce pincement permet aussi d'assurer la liaison électrique entre l'élément filaire et le borne de connexion électrique 5.

Une rainure 4 peut comporter une pluralité de bornes de connexion connectées à un même élément filaire.

L'élément filaire peut servir de bus de données, d'alimentation électrique de l'élément à puce, ou d'antenne de la puce.

On comprend que la puce 2a de l'élément à puce 2 peut alors être une puce de traitement de données, une puce RFID, une diode électroluminescente, etc.

Dans le cadre d'une diode électroluminescente, le capot et/ou l'élément à puce peuvent être transparent à la lumière émise par la diode, et par exemple conformés de sorte à agir en tant que lentille associée à la diode.

Un procédé de fabrication comporte une étape de réalisation d'au moins un capot tel que décrit dans ses différentes réalisation ci-dessus.

Plus précisément, l'étape de réalisation du capot peut comprendre une étape de formation d'une première partie 14 d'un empilement de couches électriquement isolantes (Figure 10), ainsi qu'une étape de formation d'une deuxième partie 15 de l'empilement de couches électriquement isolantes configurée de sorte à délimiter, avec la première partie 14 de l'empilement de couches, l'épaulement 3 destiné à délimiter au moins en partie la première rainure 4. Ces deux étapes de formation peuvent être réalisées en une ou plusieurs étapes de fraisage d'une partie de l'empilement de couches afin de délimiter les première et deuxième parties. Par exemple, pour stopper le fraisage, il est possible de l'arrêter lors de la détection d'un contact de la fraise avec une métallisation réalisée entre deux couches de l'empilement.

En outre, le cas échéant, l'étape de réalisation du capot 1 comprend une étape de réalisation d'au moins une borne de connexion électrique 5 au niveau de l'épaulement 3, d'au moins un plot de contact électrique 6 au niveau de la deuxième partie 15 de empilement de couches (en particulier au niveau d'une surface 7 destinée à l'assemblage du capot avec un élément à puce associé), et d'un élément de liaison électrique (non représenté) cheminant dans la deuxième partie 15 de empilement de couches, ou dans la première partie 14 et la deuxième partie 15 de l'empilement de couches électriquement isolantes. On comprend que cette étape de réalisation peut être faite au cours d'étapes de formation de la première partie 14 et de la deuxième partie 15 de l'empilement de couches puisqu'à certains endroits l'élément de liaison peut traverser une ou plusieurs couches de l'empilement, ou être pris en sandwich entre deux couches de l'empilement.

Il a été décrit ci-dessus comment réaliser un capot. Cependant, dans le cadre d'une industrialisation de masse, il a résulté le développement d'un procédé particulier permettant de réaliser une pluralité de capots.

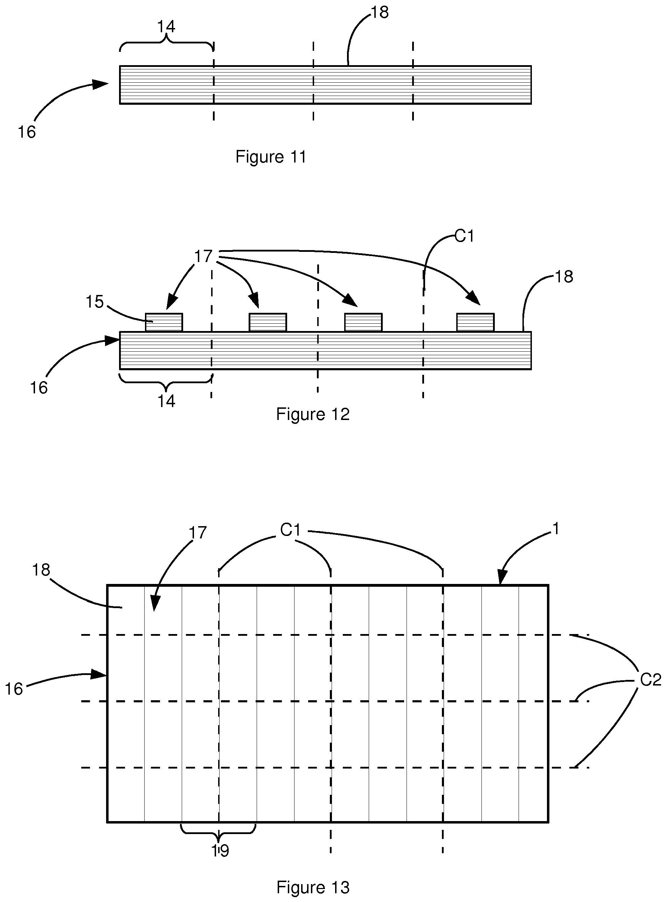

Ainsi, dans le cas où l'étape de formation permet de réaliser une pluralité de capots, cette dernière comporte, comme illustré aux figures 11 à 13, une étape de formation d'un premier ensemble 16 de couches superposées électriquement isolantes. Ce premier ensemble de couches 16 va être destiné à former une pluralité de premières parties d'empilement de couches 14. Ces différentes premières parties 14 d'empilement de couches ont des séparations virtuelles indiquées en pointillés aux figures 11 et 12. En outre, l'étape de réalisation de la pluralité de capots comporte une étape de formation d'une pluralité de deuxièmes ensembles 17 de couches électriquement isolantes superposées sensiblement parallèles les uns aux autres et s'étendant chacun à partir d'une même face 18 du premier ensemble 16 de couches, les deuxièmes ensembles de couches 17 adjacents étant séparés par une portion de séparation 19 de la face 18 du premier ensemble 16 de couches les portant. Ainsi, selon la figure 12, l'assemblage du premier ensemble 16 et du deuxième ensemble 17 de couches présente une section en forme de créneaux.

Il est possible d'obtenir une telle section en forme de créneau du fait que les technologies récentes de PCB permettent de réaliser des cavités entre des couches. Ceci permet d'obtenir une succession de bandes à la place d'une couche complète. Bien entendu, il est aussi possible, de manière non préférentielle, de réaliser une unique superposition de couches, puis de scier partiellement la structure obtenue de sorte à former des tranchées pour obtenir la structure telle que représentée aux figures 12 et 13 (par exemple le fraisage décrit ci-dessus peut être appliqué ici), ou encore de réaliser des trous borgnes à certains endroits afin de former au moins un épaulement de chaque futur capot.

Ensuite, le procédé peut comporter une étape d'individualisation des capots 1. Cette étape d'individualisation des capots peut comporter une première étape de découpe du premier ensemble 16 de couches au niveau de chaque portion de séparation 19 selon une première ligne de découpe C1 correspondante, et une deuxième étape de découpe du premier ensemble 16 de couches et du deuxième ensemble 17 de couches selon au moins une deuxième ligne de découpe C2 sécante à la première ligne de découpe C1 (de préférence plusieurs deuxièmes lignes de découpes parallèles et sécantes à la première ligne de découpe). La première étape de découpe peut être réalisée avant ou après la deuxième étape de découpe.

Afin de limiter les étapes d'assemblage d'un élément à puce avec son capot associé, avant l'étape d'individualisation des capots, le procédé peut comporter (figure 14) une étape de report d'un substrat 20 comprenant une pluralité d'éléments à puce 2 de sorte à associer aux futurs capots 1 les éléments à puce.

De préférence, les première et deuxième étapes de découpe sont configurées de sorte à séparer aussi les différents éléments à puce les uns des autres après l'étape de report du substrat 20.

Ainsi, après les première et deuxième étapes de découpe, un capot est associé à un élément à puce lui correspondant.

Bien entendu, l'étape de réalisation de la pluralité de capots peut aussi comporter pour chaque futur capot les étapes suivantes : réaliser au moins une borne de connexion électrique au niveau du premier ensemble 16 de couches ou au niveau du deuxième ensemble 17 de couches correspondant ; réaliser au moins un plot de contact électrique au niveau du premier ensemble 16 ou du deuxième ensemble 17 de couches correspondant (notamment au niveau de surfaces destinées au montage avec les éléments à puce) ; et réaliser au moins un élément de liaison électrique cheminant dans le premier ensemble 16 de couches et/ou dans le deuxième ensemble 17 de couches correspondant, et reliant électriquement ladite borne de connexion électrique et ledit plot de contact électrique.

Il est à noter que, comme illustré à la figure 15, le capot 1 peut comporter un empilement formé par: une première partie 100 de l'empilement de couches; une deuxième partie 101 de l'empilement de couches délimitant avec la première partie 100 au moins un premier épaulement ; une troisième partie 102 de l'empilement de couches de dimensions sensiblement égales à la première partie 100 de l'empilement de couches configurée de sorte à délimiter une rainure avec le premier épaulement ; une quatrième partie 103 de l'empilement de couches délimitant avec la troisième partie 102 de l'empilement de couches au moins un deuxième épaulement. L'élément à puce 2, de préférence de mêmes dimensions que la première partie 100 et que la troisième partie 102, délimite avec le deuxième épaulement une autre rainure. Différents éléments filaires 12 peuvent être associés aux différentes rainures ainsi formées.

Des bornes de connexion de différentes rainures peuvent être routées vers la surface 7 de la quatrième partie 103 montée sur l'élément à puce 2 de sorte à les connecter à des organes de connexion de l'élément à puce 2.

Avantageusement, une borne de connexion peut être formée par une saillie électriquement isolante métallisée ou par une croissance galvanique.

On comprend de tout ce qui a été dit ci-dessus en relation avec le procédé de fabrication, que l'étape de réalisation d'au moins un capot est telle que, pour chaque capot, elle peut comporter : une étape de formation d'au moins un plot de contact électrique 6 agencé au niveau d'une surface d'assemblage 7 de l'empilement destinée à être montée sur une face de l'élément à puce 2 ; une étape de formation d'au moins une borne de connexion électrique 5, 5' agencée au niveau d'une paroi de l'épaulement 3 ; et une étape de formation d'un élément de liaison électrique 8 reliant électriquement ladite borne de connexion électrique 5 au plot de contact électrique 6.

Bien entendu, il est aussi compris que le procédé peut comporter de manière générale pour chaque capot : une étape de formation d'un empilement d'une pluralité de couches électriquement isolantes 1a délimitant au moins un épaulement 3 formant une partie d'une première rainure de logement 4 d'un élément filaire 12. Cette étape de formation de l'empilement peut comporter les étapes de formation des première et deuxième parties 14, 15 telles que décrites ci-avant ou être résultante, après individualisation des capots, des étapes de formation du premier ensemble de couches 16 et de la pluralité de deuxièmes ensembles 17 de couches telles que décrites ci-avant.

La figure 16 permet de donner des dimensions préférées, mais non limitatives, d'un dispositif représenté en vue éclatée. Ainsi, la dimension d1 peut être comprise entre 100µm et 700µm, la dimension d2 peut être comprise entre 200µm et 700µm, la dimension d3 peut être comprise entre 80µm et 150µm, la dimension d4 peut être comprise entre 80µm et 150µm, la dimension d5 peut être comprise entre 400µm et 2000µm, la dimension d6 peut être comprise entre 400µm et 1000µm.

L'élément de liaison 8 peut être réalisé en cuivre.

Les couches électriquement isolantes peuvent être réalisées à base de céramique, de polymère électriquement isolant, ou de FR-4 (acronyme de l'anglais « Flame Resistant 4 » pour résistant à la flamme 4). Le FR-4 peut comporter une matrice polymère époxy imprégnant une armature en fibre de verre.

La présente invention, permet de réaliser des textiles intelligents en incorporant par exemple à un textile un dispositif tel que décrit précédemment.

Dans le cadre d'un routage électrique entre le plot de contact électrique disposé au niveau de la surface 7 et la borne de connexion 5, la borne de connexion 5 peut se trouver n'importe où au niveau du capot. Par exemple à la figure 8, la borne de connexion additionnelle 9 pourrait être disposée au niveau de la paroi latérale de la deuxième rainure 4' proximale de la paroi latérale de la première rainure 4 portant la borne de connexion 5, ceci permettant par exemple de relier plus facilement ces bornes entre elles.

## Revendications

1. Capot (1) destiné à être assemblé avec au moins un élément à puce (2), ledit capot comportant :
- un empilement d'une pluralité de couches électriquement isolantes (1a) délimitant au moins un épaulement (3) formant une partie d'une première rainure de logement (4) d'un élément filaire (12),
- au moins un plot de contact électrique (6, 6') agencé au niveau d'une surface d'assemblage (7) de l'empilement destinée à être montée sur une face de l'élément à puce (2),
- au moins une borne de connexion électrique (5, 5') agencée au niveau d'une paroi de l'épaulement (3),
- un élément de liaison électrique (8, 8') reliant électriquement ladite borne de connexion électrique (5, 5') au plot de contact électrique (6, 6'),
la borne de connexion électrique (5, 5') permettant de connecter électriquement l'élément filaire (12) encastré dans la rainure (4) à la puce de l'élément à puce (2).

2. Capot selon la revendication 1, **caractérisé en ce que** la paroi de l'épaulement (3) associée à la borne de connexion électrique (5) est inclue dans un plan décalé par rapport au plan incluant la surface d'assemblage (7).

3. Capot selon les revendications 1 ou 2, **caractérisé en ce que** l'élément de liaison électrique (8) comporte au moins un premier élément électriquement conducteur (8a) intercalé entre deux couches électriquement isolantes de l'empilement.

4. Capot selon la revendication 3, **caractérisé en ce que** l'élément de liaison électrique (8) comporte au moins un deuxième élément électriquement conducteur (8b) séparé du premier élément électriquement conducteur (8a) par au moins une des couches électriquement isolantes de l'empilement, et **en ce que**
ladite au moins une couche électriquement isolante séparant les premier et deuxième éléments électriquement conducteurs (8a, 8b) comporte un trou traversé par un troisième élément électriquement (8c) conducteur de l'élément de liaison électrique (8), ledit troisième élément électriquement conducteur (8c) reliant électriquement le premier élément électriquement conducteur (8a) au deuxième élément électriquement conducteur (8b).

5. Capot selon l'une quelconque des revendications 1 à 4, **caractérisé en ce que** l'empilement (1) comporte un circuit imprimé dont au moins une piste imprimée, notamment entre deux couches électriquement isolantes superposées, forme au moins une partie de l'élément de liaison électrique (8).

6. Capot selon l'une quelconque des revendications précédentes, **caractérisé en ce que** l'épaulement (3) coopère avec un autre épaulement (3') dudit capot de sorte à délimiter la première rainure (4).

7. Capot selon l'une quelconque des revendications précédentes, **caractérisé en ce qu'**il comporte au moins une deuxième rainure (4'), dissociée de l'épaulement (3) de la première rainure (4), dont les parois sont formées toutes ou en partie par des faces du capot, et **en ce que** ledit capot (1) comprend au moins une borne de connexion électrique additionnelle (9) formée au niveau d'une des parois de la deuxième rainure (4'), et **en ce que**
l'élément de liaison électrique (8) relie électriquement la borne de connexion électrique additionnelle (9) audit plot de contact électrique (6), et/ou **en ce que** la borne de connexion électrique additionnelle (9) est reliée électriquement à un plot de contact électrique additionnel (10), disposé au niveau de la surface (7) destinée à être montée sur la face de l'élément à puce (2), par un élément de liaison électrique additionnel (11).

8. Dispositif comportant :
- un élément à puce (2) muni d'au moins une puce (2a) électronique,
- un capot (1) selon l'une quelconque des revendications précédentes, assemblé à l'élément à puce,
- au moins une rainure (4) destinée à recevoir un élément filaire (12) et délimitée au moins en partie par l'épaulement (3) du capot (1), et,
- au moins une borne de connexion électrique (5) disposée dans la rainure (4) et reliée électriquement à ladite puce (2a) de l'élément à puce (2).

9. Dispositif selon la revendication 8, **caractérisé en ce que** l'élément à puce (2) comprend au moins un organe de connexion électrique (13) de la puce (2a) relié électriquement à un plot de contact électrique (6) associé du capot (1) de sorte à relier électriquement la puce (2a) à la borne de connexion électrique (5) disposée au niveau de l'épaulement (3) du capot (1).

10. Assemblage comprenant un dispositif selon l'une des revendications 8 à 9 et un élément filaire (12) au moins partiellement électriquement conducteur monté dans la rainure (4), ledit élément filaire (12) étant en contact électrique avec la borne de connexion électrique (5).

11. Procédé pour la fabrication d'un capot selon l'une des revendications 1 à 7 avec une étape de réalisation du capot comprenant :
- une étape de formation d'une première partie (14) d'un empilement de couches électriquement isolantes,
- une étape de formation d'une deuxième partie (15) de l'empilement de couches électriquement isolantes configurée de sorte à délimiter, avec la première partie (14) de l'empilement de couches, l'épaulement (3) destiné à délimiter au moins en partie la première rainure (4),
une étape de réalisation d'une borne de connexion électrique (5) au niveau de l'épaulement (3), d'au moins un plot de contact électrique (6) au niveau de la deuxième partie (15) de empilement de couches, et d'un élément de liaison électrique (8) cheminant dans la deuxième partie (15) de empilement de couches, ou dans la première partie (14) et la deuxième partie (15) de l'empilement de couches électriquement isolantes.

12. Procédé selon la revendication 11, **caractérisé en ce que** l'étape de réalisation permettant de réaliser une pluralité de capots, elle comporte :
- une étape de formation d'un premier ensemble (16) de couches superposées électriquement isolantes,
- une étape de formation d'une pluralité de deuxièmes ensembles (17) de couches électriquement isolantes superposées sensiblement parallèles les uns aux autres et s'étendant chacun à partir d'une même face (18) du premier ensemble de couches (16), les deuxièmes ensembles de couches (17) adjacents étant séparés par une portion de séparation (19) de la face (18) du premier ensemble (16) de couches les portant.

13. Procédé selon la revendication précédente, **caractérisé en ce qu'**il comporte une étape d'individualisation des capots.

14. Procédé selon l'une des revendications 12 à 13 en ce que l'étape de formation de la pluralité de capots comporte pour chaque futur capot les étapes suivantes :
- réaliser au moins une borne de connexion électrique (5) au niveau du premier ensemble (16) de couches ou au niveau du deuxième ensemble (17) de couches correspondant,
- réaliser au moins un plot de contact électrique (6) au niveau du premier ensemble (16) ou du deuxième ensemble (17) de couches correspondant,
- réaliser au moins un élément de liaison électrique (8) cheminant dans le premier ensemble (16) de couches et/ou dans le deuxième ensemble (17) de couches correspondant, et reliant électriquement ladite borne de connexion électrique (5) et ledit plot de contact électrique (6).

## Patentansprüche

1. Kappe (1), welche dazu bestimmt ist, mit mindestens einem Chipelement (2) zusammengebaut zu werden, wobei die Kappe umfasst:
- einen Stapel mehrerer elektrisch isolierender Schichten (1a), welche mindestens eine Schulter (3) begrenzen, die einen Teil einer ersten Aufnahmenut (4) eines Drahtelements (12) bildet,
- mindestens eine elektrische Kontaktstelle (6, 6'), welche auf der Höhe einer Montagefläche (7) des Stapels angeordnet ist, die dazu bestimmt ist, an einer Fläche des Chipelements (2) montiert zu werden,
- mindestens eine elektrische Anschlussklemme (5, 5'), die auf der Höhe einer Wand der Schulter (3) angeordnet ist,
- ein elektrisches Anschlusselement (8, 8'), das die elektrische Anschlussklemme (5, 5') mit der elektrischen Kontaktstelle (6, 6') elektrisch verbindet, wobei es die elektrische Anschlussklemme (5, 5') ermöglicht, das Drahtelement (12), das in der Nut (4) eingebaut ist, mit dem Chip des Chipelements (2) elektrisch zu verbinden.

2. Kappe nach Anspruch 1, **dadurch gekennzeichnet, dass** die Wand der Schulter (3), die mit der elektrischen Anschlussklemme (5) assoziiert ist, in einer Ebene eingeschlossen ist, die in Bezug auf eine Ebene, welche die Montagefläche (7) einschließt, verschoben ist.

3. Kappe nach Anspruch 1 oder 2, **dadurch gekennzeichnet, dass** das elektrische Anschlusselement (8) mindestens ein erstes elektrisches Leiterelement (8a) umfasst, das zwischen zwei elektrisch isolierenden Schichten des Stapels angeordnet ist.

4. Kappe nach Anspruch 3, **dadurch gekennzeichnet, dass** das elektrische Anschlusselement (8) mindestens ein zweites elektrisches Leiterelement (8b) umfasst, das von dem ersten elektrischen Leiterelement (8a) durch mindestens eine der elektrisch isolierenden Schichten des Stapels getrennt ist, und
dass die mindestens eine elektrisch isolierende Schicht, die das erste und zweite elektrische Leiterelement (8a, 8b) trennt, ein Loch umfasst, das von einem dritten elektrischen Leiterelement (8c) des elektrischen Anschlusselements (8) durchquert wird, wobei das dritte elektrische Leiterelement (8c) das erste elektrische Leiterelement (8a) mit dem zweiten elektrischen Leiterelement (8b) elektrisch verbindet.

5. Kappe nach einem der Ansprüche 1 bis 4, **dadurch gekennzeichnet, dass** der Stapel (1) eine gedruckte Schaltung umfasst, von der mindestens eine gedruckte Bahn, insbesondere zwischen zwei übereinanderliegenden elektrisch isolierenden Schichten, mindestens einen Teil des elektrischen Anschlusselements (8) bildet.

6. Kappe nach einem der vorhergehenden Ansprüche, **dadurch gekennzeichnet, dass** die Schulter (3) mit einer anderen Schulter (3') der Kappe derart zusammenwirkt, dass die erste Nut (4) begrenzt wird.

7. Kappe nach einem der vorhergehenden Ansprüche, **dadurch gekennzeichnet, dass** diese mindestens eine zweite Nut (4') umfasst, die von der Schulter (3) der ersten Nut (4) getrennt ist, deren Wände zur Gänze oder teilweise durch Flächen der Kappe gebildet sind, und
dass die Kappe (1) mindestens eine zusätzliche elektrische Anschlussklemme (9) umfasst, die auf der Höhe einer der Wände der zweiten Nut (4') gebildet ist, und
dass das elektrische Anschlusselement (8) die zusätzliche elektrische Anschlussklemme (9) mit der elektrischen Kontaktstelle (6) elektrisch verbindet, und/oder dass die zusätzliche elektrische Anschlussklemme (9) mit einer zusätzlichen elektrischen Kontaktstelle (10) elektrisch verbunden ist, welche auf der Höhe der Fläche (7) angeordnet ist, die dazu bestimmt ist, an der Fläche des Chipelements (2) durch ein zusätzliches elektrisches Anschlusselement (11) montiert zu werden.

8. Vorrichtung, umfassend:
- ein Chipelement (2), das mit mindestens einem elektronischen Chip (2a) versehen ist,
- eine Kappe (1) nach einem der vorhergehenden Ansprüche, die mit dem Chipelement zusammengebaut ist,
- mindestens eine Nut (4), die dazu bestimmt ist, ein Drahtelement (12) aufzunehmen, und mindestens teilweise von der Schulter (3) der Kappe (1) begrenzt ist, und
- mindestens eine elektrische Anschlussklemme (5), die in der Nut (4) angeordnet und mit dem Chip (2a) des Chipelements (2) elektrisch verbunden ist.

9. Vorrichtung nach Anspruch 8, **dadurch gekennzeichnet, dass** das Chipelement (2) mindestens ein elektrisches Anschlussglied (13) des Chips (2a) umfasst, das mit einer elektrischen Kontaktstelle (6) elektrisch verbunden ist, die mit der Kappe (1) derart assoziiert ist, dass der Chip (2a) mit der elektrischen Anschlussklemme (5) elektrisch verbunden wird, die auf der Höhe der Schulter (3) der Kappe (1) angeordnet ist.

10. Zusammenbau, umfassend eine Vorrichtung nach einem der Ansprüche 8 bis 9 und ein mindestens teilweise elektrisch leitendes Drahtelement (12), das in der Nut (4) montiert ist, wobei das Drahtelement (12) mit der elektrischen Anschlussklemme (5) in elektrischem Kontakt steht.

11. Verfahren zur Herstellung einer Kappe nach einem der Ansprüche 1 bis 7, mit einem Schritt der Ausbildung der Kappe, umfassend:
- einen Schritt der Bildung eines ersten Teils (14) eines Stapels elektrisch isolierender Schichten,
- einen Schritt der Bildung eines zweiten Teils (15) des Stapels elektrisch isolierender Schichten, der derart ausgelegt wird, dass, mit dem ersten Teil (14) des Schichtstapels, die Schulter (3) begrenzt wird, die dazu bestimmt ist, mindestens teilweise die erste Nut (4) zu begrenzen,
- einen Schritt der Ausbildung einer elektrischen Anschlussklemme (5) auf der Höhe der Schulter (3), mindestens einer elektrischen Kontaktstelle (6) auf der Höhe des zweiten Teils (15) des Schichtstapels und eines elektrischen Anschlusselements (8), das sich in dem zweiten Teil (15) des Schichtstapels oder in dem ersten Teil (14) und in dem zweiten Teil (15) des Stapels elektrisch isolierender Schichten erstreckt.

12. Verfahren nach Anspruch 11, **dadurch gekennzeichnet, dass** der Ausbildungsschritt die Ausbildung mehrerer Kappen gestattet, wobei dieser umfasst:
- einen Schritt der Bildung einer ersten Einheit (16) übereinanderliegender elektrisch isolierender Schichten,
- einen Schritt der Bildung mehrerer zweiter Einheiten (17) übereinanderliegender elektrisch isolierender Schichten, die im Wesentlichen zueinander parallel sind und sich jeweils von derselben Fläche (18) der ersten Einheit (16) von Schichten erstrecken, wobei die zweiten benachbarten Einheiten (17) von Schichten durch einen Trennteil (19) der Fläche (18) der ersten Einheit (16) von Schichten getrennt werden, die diese trägt.

13. Verfahren nach dem vorhergehenden Anspruch, **dadurch gekennzeichnet, dass** dieses einen Schritt der Vereinzelung der Kappen umfasst.

14. Verfahren nach einem der Ansprüche 12 bis 13, **dadurch gekennzeichnet, dass** der Schritt der Bildung der mehreren Kappen für jede künftige Kappe die folgenden Schritte umfasst:
- Ausbildung mindestens einer elektrischen Anschlussklemme (5) auf der Höhe der ersten Einheit (16) von Schichten oder auf der Höhe der zweiten Einheit (17) entsprechender Schichten,
- Ausbildung mindestens einer elektrischen Kontaktstelle (6) auf der Höhe der ersten Einheit (16) oder der zweiten Einheit (17) entsprechender Schichten,
- Ausbildung mindestens eines elektrischen Anschlusselements (8), das sich in der ersten Einheit (16) von Schichten und/oder in der zweiten Einheit (17) entsprechender Schichten erstreckt und die elektrische Anschlussklemme (5) und die elektrische Kontaktstelle (6) elektrisch verbindet.

## Claims

1. Cap (1) intended to be assembled with at least one chipped element (2), said cap comprising:
- a stack of a plurality of electrically insulating layers (1 a) delimiting at least one shoulder (3) forming a part of a first groove (4) for housing a wired element (12),
- at least one electrical bump contact (6, 6') arranged at an assembly surface (7) of the stack intended to be mounted on a face of the chipped element (2),
- at least one electrical connection terminal (5, 5') arranged at a wall of the shoulder (3),
- an electrical link element (8, 8'), electrically linking said electrical connection terminal (5, 5') to the electrical bump contact (6, 6'), the electrical connection terminal (5, 5') making it possible to electrically connect the wired element (12) embedded in the groove (4) to the chip of the chipped element (2).

2. Cap according to Claim 1, **characterized in that** the wall of the shoulder (3) associated with the electrical connection terminal (5) is included in a plane that is offset relative to the plane including the assembly surface (7).

3. Cap according to Claim 1 or 2, **characterized in that** the electrical link element (8) comprises at least one first electrically conductive element (8a) inserted between two electrically insulating layers of the stack.

4. Cap according to Claim 3, **characterized in that** the electrical link element (8) comprises at least one second electrically conductive element (8b) separated from the first electrically conductive element (8a) by at least one of the electrically insulating layers of the stack and **in that** said at least one electrically insulating layer separating the first and second electrically conductive elements (8a, 8b) comprises a hole that is passed through by a third electrically conductive element (8c) of the electrical link element (8), said third electrically conductive element (8c) electrically linking the first electrically conductive element (8a) to the second electrically conductive element (8b).

5. Cap according to any one of Claims 1 to 4, **characterized in that** the stack (1) comprises a printed circuit of which at least one printed track, notably between two superposed electrically insulating layers, forms at least a part of the electrical link element (8).

6. Cap according to any one of the preceding claims, **characterized in that** the shoulder (3) co-operates with another shoulder (3') of said cap so as to delimit the first groove (4).

7. Cap according to any one of the preceding claims, **characterized in that** it comprises at least one second groove (4'), dissociated from the shoulder (3) of the first groove (4), the walls of which are formed wholly or partly by faces of the cap, and **in that** said cap (1) comprises at least one additional electrical connection terminal (9) formed at one of the walls of the second groove (4'), and **in that** the electrical link element (8) electrically links the additional electrical connection terminal (9) to said electrical bump contact (6), and/or **in that** the additional electrical connection terminal (9) is electrically linked to an additional electrical bump contact (10), positioned at the surface (7) intended to be mounted on the face of the chipped element (2), by an additional electrical link element (11).

8. Device comprising:
- a chipped element (2) provided with at least one electronic chip (2a),
- a cap (1) according to any one of the preceding claims, assembled with the chipped element,
- at least one groove (4) intended to receive a wired element (12) and delimited at least partly by the shoulder (3) of the cap (1), and,
- at least one electrical connection terminal (5) positioned in the groove (4) and electrically linked to said chip (2a) of the chipped element (2).

9. Device according to Claim 8, **characterized in that** the chipped element (2) comprises at least one electrical connection member (13) of the chip (2a) electrically linked to an associated electrical bump contact (6) of the cap (1) so as to electrically link the chip (2a) to the electrical connection terminal (5) positioned at the shoulder (3) of the cap (1).

10. Assembly comprising a device according to one of Claims 8 to 9 and an at least partially electrically conductive wired element (12) mounted in the groove (4), said wired element (12) being in electrical contact with the electrical connection terminal (5).

11. Method for the manufacture of a cap according to any one of the claims 1 to 7 with a step of producing the cap comprising:
- a step of forming a first part (14) of a stack of electrically insulating layers,
- a step of forming a second part (15) of the stack of electrically insulating layers configured so as to delimit, with the first part (14) of the stack of layers, the shoulder (3) intended to at least partly delimit the first groove (4),
- a step of producing an electrical connection terminal (5) at the shoulder (3), at least one electrical bump contact (6) at the second part (15) of the stack of layers, and an electrical link element (8) running through the second part (15) of the stack of layers, or through the first part (14) and the second part (15) of the stack of electrically insulating layers.

12. Method according to Claim 11, **characterized in that**, the production step making it possible to produce a plurality of caps, it comprises:
- a step of forming a first set (16) of superposed electrically insulating layers,
- a step of forming a plurality of second sets (17) of superposed electrically insulating layers substantially parallel to one another and each extending from a same face (18) of the first set of layers (16), the second sets of adjacent layers (17) being separated by a separation portion (19) of the face (18) of the first set of layers (16) bearing them.

13. Method according to the preceding claim, **characterized in that** it comprises a step of individualization of the caps.

14. Method according to one of Claims 12 to 13, **characterized in that** the step of forming the plurality of caps comprises, for each future cap, the following steps:
- producing at least one electrical connection terminal (5) at the first set (16) of layers or at the corresponding second set (17) of layers,
- producing at least one electrical bump contact (6) at the first set (16) or the corresponding second set (17) of layers,
- producing at least one electrical link element (8) running through the first set (16) of layers and/or through the corresponding second set (17) of layers, and electrically linking said electrical connection terminal (5) and said electrical bump contact (6).
